Europäisches Patentamt

European Patent Office

Office européen des brevets

(11) Publication number: **0 043 293**
A1

# (12) EUROPEAN PATENT APPLICATION

(21) Application number: **81303001.2**

(22) Date of filing: **01.07.81**

(51) Int. Cl.³: **G 01 N 29/04**
**G 01 S 15/89, G 03 H 3/00**
**H 03 D 13/00**

(30) Priority: **02.07.80 JP 89142/80**

(43) Date of publication of application:
**06.01.82 Bulletin 82/1**

(84) Designated Contracting States:
**AT BE CH DE FR GB IT LI LU NL SE**

(71) Applicant: **Hitachi, Ltd.**
**5-1, Marunouchi 1-chome**
**Chiyoda-ku Tokyo 100(JP)**

(72) Inventor: **Takahashi, Fuminobu**
**14 Higashitagacho-3-chome**
**Hitachi-shi(JP)**

(74) Representative: **Ellis, Edward Lovell et al,**
**MEWBURN ELLIS & CO. 70-72, Chancery Lane**
**London, WC2A 1AD(GB)**

(54) Digital phase detector.

(57) A digital phase detector (10) is proposed which comprises a multiple clock pulse generator (1); for producing three kinds of pulses different in the periodicity and pulse duration, and a time coincidence circuit (3) for producing a binary code of said three kinds of clock pulses upon reception of an object-modified wave from an ultrasonic transducer. This digital phase detector (10) can detect in an ultrasonic holography apparatus the phase of a digital input signal with high accuracy.

FIG. I

EP 0 043 293 A1

DIGITAL PHASE DETECTOR

The present invention relates to digital phase detectors and more particularly to a digital phase detector suitable for use with a digital-type ultrasonic holography apparatus.

The detailed construction of the digital-type ultrasonic holography apparatus is disclosed in the Japanese Patent Application Laid-Open No. 8584/79. According to the above digital-type ultrasonic holography apparatus, clock pulses (reference wave) are produced at intervals of a predetermined period of time, ultrasonic pulses are generated in synchronism with pulses which are produced by dividing the frequency of the clock pulses, coincidence in time (phase coincidence) between the reflected wave pulses (object-modified wave) received during a predetermined gate period of time and the clock pulses (reference wave) is examined, and then a coincidence pulse is produced when they coincide with each other thereby to produce a hologram by the coincidence pulse.

In this apparatus, when the phase difference between the reference wave and the object-modified wave is, for example, 0 to $\pi$ radian, a binary digit "1" is produced, and when it is $\pi$ to $2\pi$ radian, a binary digit "0" is produced. Therefore, the change of the phase (i.e. the amplitude) of interference waves or the intensity thereof depending on the phase difference can be detected only when the phase difference is within the range of 0 to π.

It is an object of the invention to provide a digital phase detector capable of detecting the phase difference between the reference wave and the object-modified wave with high accuracy.

It is another object of the invention to provide a digital phase detector capable of detecting the phase difference between the reference wave and the object-modified wave with high accuracy irrespective of the frequency of the reference wave or object-modified wave.

It is still another object of the invention to provide a digital phase detector capable of detecting the aforementioned phase difference with high accuracy even when the pulse duration of object-modified wave is short.

In accordance with the present invention, plural kinds of clock pulses are utilized for producing a binary code indicative of time function of interference wave intensity, and upon reception of object-modified wave pulse, the binary code at this time is outputted so that the interference wave intensity can be indicated by digital pulses.

Other objects, features and advantages of the present invention will become apparent from the following detailed description of preferred embodiment thereof taken in conjunction with accompanying drawings, in which:

Fig. 1 is a time chart for illustrating the principle of the present invention in which only reference waves are shown by actual waveforms;

Fig. 2 shows the intensity of the interference wave with respect to a period of time, $t_d$ at which the object-modified wave is received;

Fig. 3 is a block diagram of a preferred embodiment of the present invention;

Fig. 4 is a time chart for illustrating the waveforms of input and output at each part of the digital phase detector shown in Fig. 3; and

Fig. 5 is a specific circuit arrangement of the digital phase detector shown in Fig. 3.

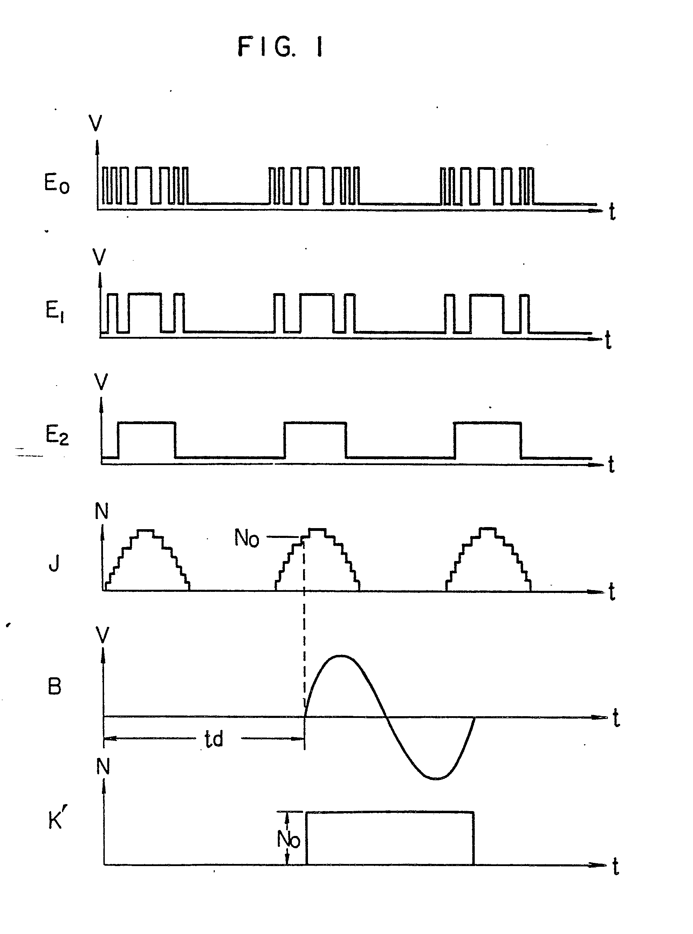

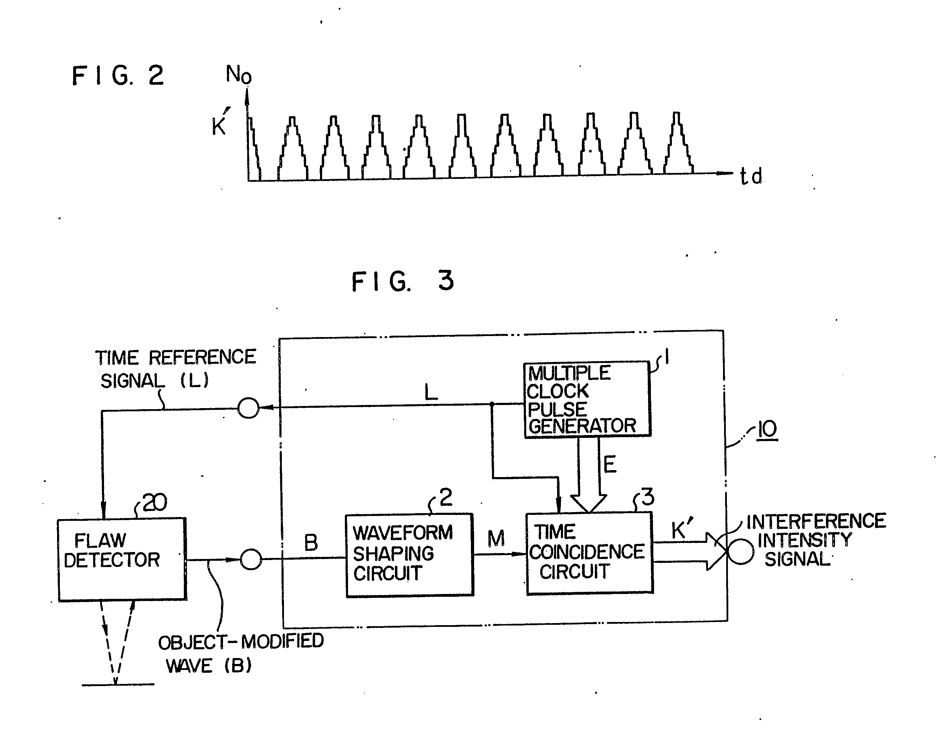

The principle of the present invention will first be described with reference to Figs. 1 and 2.

The present invention employs a plurality of clock pulses as reference signals. These clock pulses have, for example, different periodicity and pulse duration as shown in Fig. 1 by signals $E_0$, $E_1$ and $E_2$. The amplitude of the positive sine wave as indicated by signal J is represented by digital values of three bits as a binary code "001", "010", "011", "100" or the like which is obtained by the combination of the clock pulses $E_0$, $E_1$ and $E_2$.

As disclosed in the Japanese Patent Application Laid-Open No. 8584/79 a coincidence is examined between the plurality of reference waves and the object-modified wave, i.e., if the reference wave is in a predetermined state upon reception of object-modified wave, a coincidence signal is outputted as indicated by signal D in Fig. 1. The digital value ($N_o$) represents the interference intensity. Fig. 1 is a waveform diagram to which reference is made for illustrating the principle of the present invention, and hence the signal K' is different from the actual waveform. Fig. 2 shows the relationship between a point of time when the object-modified wave is received, or delay time $t_d$ and the intensity signal K' of interference wave.

Referring to Fig. 2, although the signal K' is positive, the intensity of the negative interference wave can be outputted in digital value by using code bit signal as well.

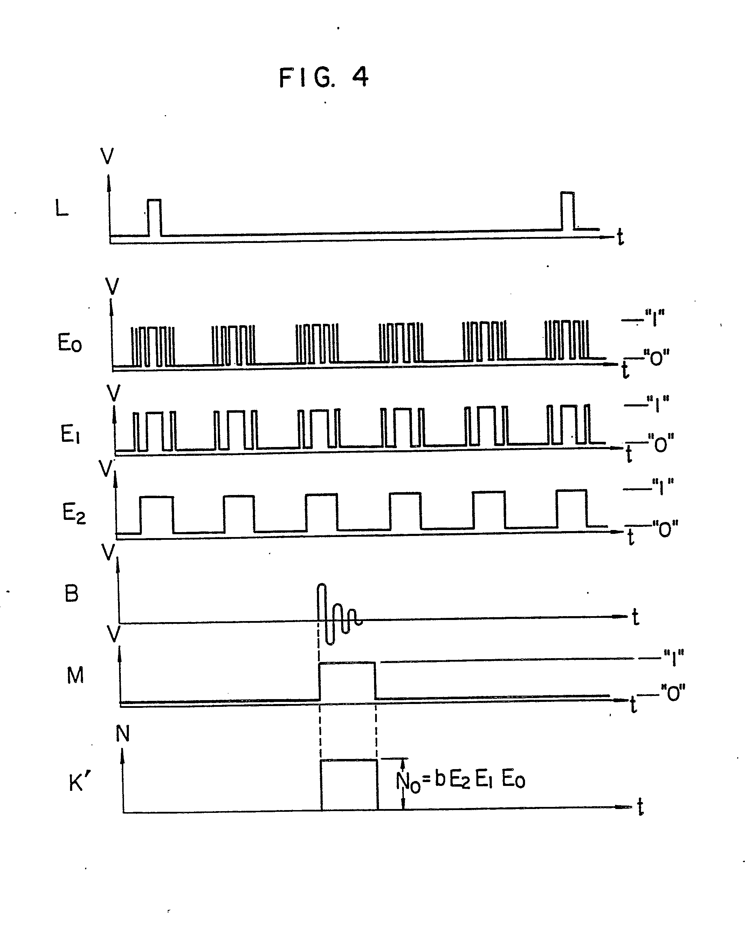

Fig. 3 is a block diagram of a preferred embodiment of the invention, in which a digital phase detector 10 includes a multiple clock pulse generator 1, a waveform shaping circuit 2, and a time coincidence circuit 3. In addition, numeral 20 designates a flaw detector including an ultrasonic transducer. The multiple clock pulse generator 1 generates a time reference pulse L for determining the time origin and clock pulses $E_0$, $E_1$ and $E_2$ as shown in Fig. 1 (see Fig. 4). This time reference pulse L controls the time interval of the transmission pulse generated from the flaw detector 20. The waveform shaping circuit 2 is supplied with an object-modified wave B from the flaw detector 20, so as to produce a digital pulse M of TTL level "1" during the pulse width of signal B or above in synchronism with the leading edge of the signal B. The time coincidence circuit 3 receives a bit signal E from the multiple clock pulse generator 1 and holds the level of the bit signal E at the time of leading edge of the pulse signal M from the waveform shaping circuit 2 for the pulse width of the pulse signal M, which level is outputted as an interference intensity signal K'. The operation waveforms at each part of the embodiment of Fig. 3 are shown in Fig. 4. A signal L is a time reference pulse indicating the time origin, which is used to generate a ultrasonic pulse in synchronism with the leading edge of the signal L. The signals $E_0$, $E_1$ and $E_2$ are clock pulses from the multiple clock pulse generator 1 and correspond to a bit signal of three bits. The signal B is a reflected wave (object-modified wave) signal which is supplied from the external flaw detector 20 to the waveform shaping circuit 2 where it is converted to the digital pulse signal M. The signal K' is a three-bit digital signal obtained by holding the level of the signal E at the time of leading edge of the signal M and during a period of time corresponding to the pulse width of a signal M.

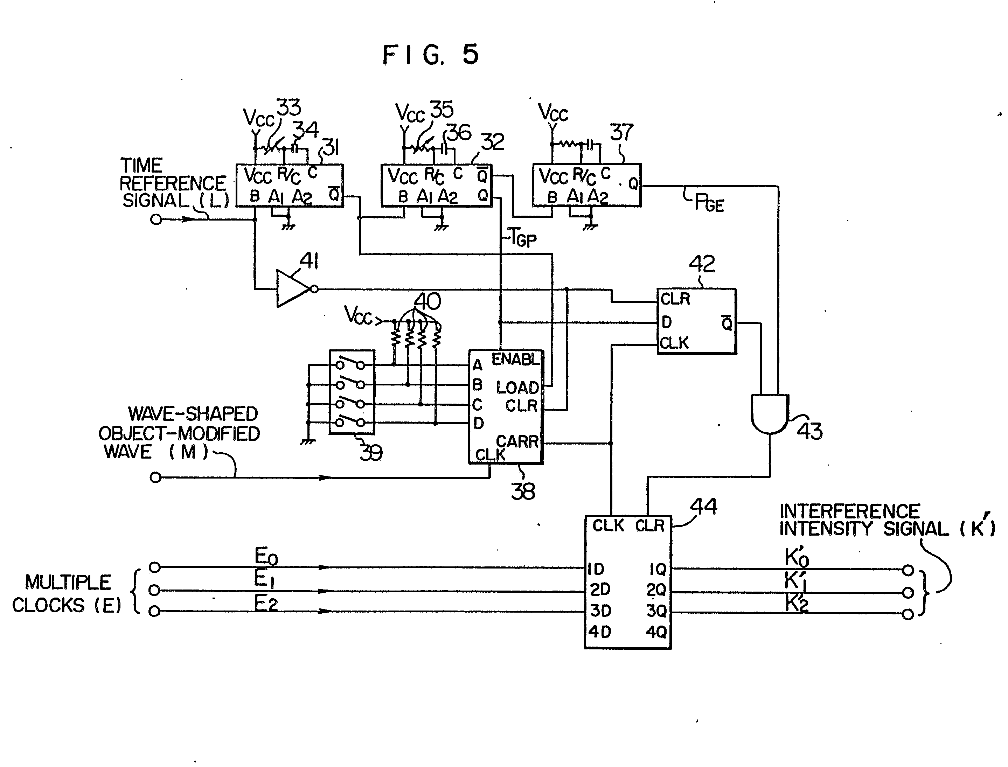

Fig. 5 is a circuit diagram of the time coincidence detector 3. The time reference signal L is applied to a monostable multivibrator 31 where it is delayed. This delayed signal is applied to a monostable multivibrator 32, which produces at its Q-terminal a gate pulse $T_{GP}$ of duration $T_W$ after a predetermined period of time $T_D$ has elapsed from the application of signal L thereto. The period of time $T_D$ is determined by the value of a resistor 33 and a capacitor 34 constituting the monostable multivibrator 31, and the duration $T_W$ is also determined by the value of a resistor 35 and a capacitor 36 of the monostable multivibrator 32. The Q-output of the multivibrator 32 is applied to a monostable multivibrator 37, which then produces a gate-end pulse $P_{GE}$ of duration $t_W$ in synchronism with the leading edge of the time gate pulse.

On the other hand, the object-modified wave signal M is applied to a 4-bit synchronous counter 38 which is connected with a switch 39 and resistor 40 for setting to an initial value data. In this embodiment, the initial value data is set to with hexadecimal numbers, and the timing for setting is at the leading edge of the negative logic pulse from a NOT gate 41 to which the signal L is applied. The CARRY signal from the synchronous counter 38 is outputted in synchronism with the leading edge of the object-modified signal M. However, the CARRY signal is not produced unless the object-modified signal M is the $N_F$-th pulse during the time gate pulse $T_{GP}$ (where $1 \leq N_F \leq 16$). The switch 39 in Fig. 5 is set to be $N_F = 1$. Depending on what value the switch 39 is set to, the $N_F$-th pulse alone of the maximum of 16 pulses in the signal M for the duration of the time gate pulse $T_{GP}$ can be extracted as a CARRY signal. The CARRY signal from the synchronous counter 38 is applied to a D-type edge-triggered flip-flop 42, which produces at the $\overline{Q}$ terminal a "0" level when the CARRY signal occurs for the duration of the time gate pulse, or "1" level when the CARRY signal does not occur. The output signal from the flip-flop 42 and the gate-end pulse from the Q-terminal of the monostable multivibrator 37 are applied to an AND gate 43, which produces a logic product signal. This signal is applied to the clear terminal of a D-type edge-triggered flip-flop 44. The three-bit signal to the flip-flop 44 is a signal E from the multiple clock pulse generator 1. The flip-flop 44 latches the signal E (three bits) at the time of the CARRY signal from the synchronous counter 38 and produces interference wave intensity signals $K'_0$, $K'_1$, $K'_2$ (3 bits) at terminals 1Q to 3Q. In either cases where the object-modified signal M is not outputted during a predetermined period of time after the time reference signal L has been produced (i.e. for the duration of the time gate pulse) or the number of pulses is below $N_F$ (to which the switch 39 is set), the signals

$K'_0$, $K'_1$, $K'_2$ is cleared to zero at the trailing edge of the time gate pulse even during the period of time when the signal M is outputted.

The reference signal wave and object-modified signal wave do not necessarily have the same period, and the interference wave intensity can fully be detected even though the pulse width of the object-modified signal wave is short.

While in the above embodiment clock pulses with different periodicity and pulse duration are used as reference signals which form a binary code, clock pulses with the same periodicity and pulse duration but different phase may be employed. That is, these clock pulses, when summed, may form substantially a sawtooth wave or a triangular wave.

WHAT IS CLAIMED IS

1. A digital phase detector (10) for producing the intensity of an interference signal between a digital input signal and a prepared reference signal on the basis of the phase difference between said digital input signal and said reference signal, said digital phase detector comprising:

a multiple clock pulse generator (1) for generating plural kinds of clock pulses; and

a time coincidence circuit (3) for producing a binary code of said plural kinds of clock pulses upon reception of said digital input signal.

2. A digital phase detector (10) according to Claim 1, wherein said plural kinds of clock pulses, when summed, produce substantially a positive sine wave.

3. A digital phase detector (10) according to Claim 1, wherein said plural kinds of clock pulses, when summed, produce substantially a positive saw-tooth wave.

0043293

FIG. 1

# FIG. 2

# FIG. 3

FIG. 4

$N_0 = b E_2 E_1 E_0$

FIG. 5

4/4

0043293

**0043293**

European Patent Office

**EUROPEAN SEARCH REPORT**

Application number

EP 81 30 3001.2

## DOCUMENTS CONSIDERED TO·BE RELEVANT

| Category | Citation of document with indication, where appropriate, of relevant passages | Relevant to claim |
|---|---|---|
| | GB - A - 2 000 291 (HITACHI LTD.) <br> * claims 1, 3, 4; fig. 1 to 30 * <br> --- | 1 |
| A,P | EP - A1 - 0 018 079 (HITACHI LTD.) <br> * fig. 1 to 16 * <br> -- | |
| A | DE - B2 - 2 652 770 (BUNDESANSTALT FÜR MATERIALPRÜFUNG) <br> * fig. 1 to 7 * <br> -- | |
| A | US - A - 4 C70 643 (D.T. GREEN) <br> * fig. 1 to 7 * <br> --- | |
| A | US - A - 4 021 771 (H.D. COLLINS et al.) <br> * fig. 1 to 2 * <br> --- | |
| A | US - A - 3 849 758 (J.L. PFEIFER) <br> * fig. 1 to 12; fig. 8, position 52 * <br> -- | |
| A | US - A - 3 719 922 (L.A. LOPES JR. et al.) <br> * fig. 1 to 15 * <br> --- | |
| A | US - A - 3 717 843 (H.R. FARRAH et al.) <br> * fig. 1 to 2 * <br> -- | |
| A | DE - A1 - 2 645 638 (SPERRY RAND CORP.) <br> * fig. 1 to 3 * <br> ---- | |

**CLASSIFICATION OF THE APPLICATION (Int. Cl.³)**

G 01 N 29/04
G 01 S 15/89
G 03 H 3/00
H 03 D 13/00

**TECHNICAL FIELDS SEARCHED (Int. Cl.³)**

G 01 N 29/00
G 01 S 15/00
G 03 H 3/00
H 03 D 13/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | 16-09-1981 | BREUSING |

EPO Form 1503.1 06.78